# EUROPEAN PATENT SPECIFICATION

(11) **EP 3 214 776 B1**
(45) Date of publication and mention of the grant of the patent: **05.06.2024**
(21) Application number: 15854791.9
(22) Date of filing: 16.10.2015
(51) Int. Cl.: H03M 13/11, H04B 7/08, H04J 11/00

(54) **RECEIVING DEVICE AND METHOD**
EMPFANGSVORRICHTUNG UND -VERFAHREN
DISPOSITIF ET PROCÉDÉ DE RÉCEPTION

(30) Priority: 30.10.2014 JP 2014221028
(43) Date of publication of application: 06.09.2017
(73) Proprietor: Sony Group Corporation, Tokyo 108-0075 (JP)
(72) Inventor: KAMATA Hiroyuki, Tokyo 108-0075 (JP); KOBAYASHI Kenichi, Tokyo 108-0075 (JP); OKADA Satoshi, Tokyo 108-0075 (JP)
(74) Representative: MFG Patentanwälte Meyer-Wildhagen Meggle-Freund Gerhard PartG mbB
(86) International application number: PCT/JP2015/079330
(87) International publication number: WO 2016/067939

(56) References cited:
- EP-A1- 2 701 327
- WO-A1-2009/063646
- WO-A1-2011/093074
- WO-A1-2013/136694
- WO-A1-2014/171341
- JP-A- 2010 081 029
- US-A1- 2013 044 840
- US-A1- 2014 086 229
- HO YANG ET AL: "Software-Defined DVB-T2 Demodulator using Scalable DSP Processors", IEEE TRANSACTIONS ON CONSUMER ELECTRONICS, vol. 59, no. 2, 1 January 2013 (2013-01-01), pages 428-434, XP55229224,
- Anonymous: "Digital Video Broadcasting (DVB); Frame structure channel coding and modulation for a second generation digital terrestrial television broadcasting system (DVB-T2)", ETSI EN 302 755, V1. 3.1, 1 April 2012 (2012-04-01), pages 1-188, XP055537535, Retrieved from the Internet: URL:https://www.etsi.org/deliver/etsi_en/3 02700_302799/302755/01.03.01_60/en_302755v 010301p.pdf [retrieved on 2018-12-21]
- OLIVER HAFFENDEN: "TM-T20447r1r4: T2_0447r4_DVB-T2 Implementation Guidelines v0.4.0 - T2_0447_DVB-T2_Implementation_Guidelines_0 _4_0", DVB, DIGITAL VIDEO BROADCASTING, C/O EBU - 17A ANCIENNE ROUTE - CH-1218 GRAND SACONNEX, GENEVA - SWITZERLAND , no. 4 25 July 2008 (2008-07-25), XP017817729, Retrieved from the Internet: URL:https://www.dvb.org/resources/restrict ed/members/documents/TM-T2/T2_0447r4_DVB-T 2_Implementation_Guidelines_0_4_0.zip T2_0447_DVB-T2_Implementation_Guidelines_0 _4_0.doc [retrieved on 2008-07-25]

## Description

### TECHNICAL FIELD

The present disclosure relates to reception devices and methods, and more particularly, to a reception device and a method that realize diversity in reception of data including transmission parameters in specific positions timewise.

### BACKGROUND ART

To improve reception performance in mobile environments, diversity techniques involving multiple reception devices have been developed, and today, there is a demand for diversity under the Digital Video Broadcasting-Terrestrial 2 (DVB-T2) standards.

WO 2014/171341 A1 describes a reception device, a reception method, and a program that can prevent erroneous detection of a predetermined signal, such as a P1 signal, included in, for example, a received signal such as DVB-T2.

US 2013/044840 A1 describes a digital broadcast receiver which supports diversity reception including a plurality of demodulation units and a combining unit for combining the demodulated signals.

US 2014/086229 A1 pertains to a wireless communication device comprising a demodulation section that demodulates a received signal, a decoding section that decodes an output from the demodulation section, a buffer that temporarily stores a portion of the received signal, and a header analyzing section that gives the buffer timing at which demodulation and decoding of a payload of the received signal are initiated, on the basis of a result of combination of a plurality of header sequences included in a header of the received signal and results of processing of the demodulation section and the decoding section.

EP 2 701 327 A1 pertains to a precoding method for generating, from a plurality of signals which are based on a selected modulation scheme and represented by in-phase components and quadrature components, a plurality of precoded signals that are transmitted in the same frequency band at the same time and transmitting the generated precoded signals.

OLIVER HAFFENDEN: "TM-T20447r1 r4: T2 0447r4 DVB-T2 Implementation Guidelines v0.4.0 - T2_0447_DVB-T2_Implementation_Guidelines_0_4_0", DVB, DIGITAL VIDEO BROADCASTING, C/O EBU - 17A ANCIENNE ROUTE - CH-1218 GRAND SACONNEX, GENEVA, SWITZERLAND, no. 4, 25 July 2008 (2008-07-25), XPO17817729 pertains to a second generation digital terrestrial broadcasting system (DVB-T2 having a draft physical layer specification and being divided into three basic sub-systems on the network side (SS1. SS2. SS3) and two sub-systems on the receiver side.

### CITATION LIST

### NON-PATENT DOCUMENT

Non-Patent Document 1: ETSI EN 302 755 V1.3.1, Frame structure channel coding and modulation for a second generation digital terrestrial television broadcasting system (DVB-T2) 2012, 04, the homepage of DVB, [viewed on October 9, 2014], <URL: http://www.dvb.org/technology/standards/dvb-t2>

### SUMMARY OF THE INVENTION

### PROBLEMS TO BE SOLVED BY THE INVENTION

However, in a DVB-T2 reception device, the timing to output a signal from a demodulation unit varies before and after the acquisition of transmission parameters. Therefore, it is difficult to realize diversity only with a mechanism for simply combining outputs of the respective demodulation units.

The present disclosure has been made in view of such circumstances, and is to realize diversity in reception of data including transmission control signals in specific positions timewise.

### SOLUTIONS TO PROBLEMS

According to a first aspect, the invention provides a reception device in accordance with independent claim 1. According to a second aspect, the invention provides a reception method in accordance with independent claim 5. Further aspects of the invention are set forth in the dependent claims, the drawings, and the following description.

A reception device according to one aspect of the present disclosure includes: a first demodulation unit that demodulates a multiplexed signal formed by multiplexing data and a transmission parameter including a parameter necessary for demodulating the data, the transmission parameter being located in a specific position timewise; a second demodulation unit that demodulates the multiplexed signal; a signal combining unit that combines multiplexed signals from the first and second demodulation units; and a transmission parameter processing unit that extracts the transmission parameter from the signal combined by the signal combining unit, and supplies the extracted transmission parameter to the first and second demodulation units.

When any multiplexed signal is not input from one of the first and second demodulation units, the signal combining unit may output a multiplexed signal from the other one of the first and second demodulation units to a subsequent stage.

The reception device may further include a data processing unit that processes data to be multiplexed into the signal combined by the signal combining unit, in accordance with the transmission parameter extracted by the transmission parameter processing unit.

The reception device may further include an error correction unit that performs error correction on the signal combined by the signal combining unit.

The transmission parameter may include an error correction parameter for performing the error correction, and the transmission parameter processing unit may supply the error correction parameter of the transmission parameter to the error correction unit.

The first demodulation unit, the signal combining unit, and the transmission parameter processing unit may be disposed in a first LSI, and the second demodulation unit may be disposed in a second LSI that is different from the first LSI.
It is known that LSI generally refers to a large-scale integrated circuit. A large-scale integrated circuit generally refers to an integrated circuit (IC), for example a semiconductor integrated circuit, with 1000 or more elements. A large-scale integrated circuit is also called LSI.

A reception method according to one aspect of the present disclosure includes: demodulating a multiplexed signal formed by multiplexing data and a transmission parameter including a parameter necessary for demodulating the data, the transmission parameter being located in a specific position timewise, the demodulating being performed by a first demodulation unit of a reception device; demodulating the multiplexed signal, the demodulating being performed by a second demodulation unit of the reception device; combining multiplexed signals from the first and second demodulation units; and extracting the transmission parameter from the combined signal, and supplying the extracted transmission parameter to the first and second demodulation units.

In one aspect of the present disclosure, the first demodulation unit demodulates a multiplexed signal formed by multiplexing data and a transmission parameter that is located in a specific position timewise and includes a parameter necessary for demodulating the data, and the second demodulation unit demodulates the multiplexed signal. Multiplexed signals from the first and second demodulation units are then combined, the transmission parameter is extracted from the combined signal, and the extracted transmission parameter is supplied to the first and second demodulation units.

A reception device according to another aspect of the present disclosure includes: a first demodulation unit that demodulates a multiplexed signal formed by multiplexing data and a transmission parameter including a parameter necessary for demodulating the data, the transmission parameter being located in a specific position timewise; a second demodulation unit that demodulates the multiplexed signal; a signal combining unit that combines multiplexed signals from the first and second demodulation units after acquisition of the transmission parameter; a first transmission parameter processing unit that extracts the transmission parameter from the multiplexed signal, and supplies the extracted transmission parameter to the first demodulation unit; and a second transmission parameter processing unit that extracts the transmission parameter from the multiplexed signal, and supplies the extracted transmission parameter to the second demodulation unit.

When any multiplexed signal is not input from one of the first and second demodulation units, the signal combining unit may output a multiplexed signal from the other one of the first and second demodulation units to a subsequent stage.

The reception device may further include a data processing unit that processes data to be multiplexed into the signal combined by the signal combining unit, in accordance with the transmission parameter extracted by the first transmission parameter processing unit.

The reception device may further include: a first error correction unit that performs error correction on the multiplexed signal, and supplies the signal subjected to the error correction to the first transmission parameter processing unit; and a second error correction unit that performs error correction on the multiplexed signal, and supplies the signal subjected to the error correction to the second transmission parameter processing unit.

The transmission parameter may include an error correction parameter for performing the error correction, the first transmission parameter processing unit may supply the error correction parameter of the transmission parameter to the first error correction unit, and the second transmission parameter processing unit may supply the error correction parameter of the transmission parameter to the second error correction unit.

The first demodulation unit, the signal combining unit, and the first transmission parameter processing unit may be disposed in a first LSI, and the second demodulation unit and the second transmission parameter processing unit may be disposed in a second LSI that is different from the first LSI.

A reception method according to another aspect of the present disclosure includes: demodulating a multiplexed signal formed by multiplexing data and a transmission parameter including a parameter necessary for demodulating the data, the transmission parameter being located in a specific position timewise, the demodulating being performed by a first demodulation unit of a reception device; demodulating the multiplexed signal, the demodulating being performed by a second demodulation unit of the reception device; combining multiplexed signals from the first and second demodulation units; extracting the transmission parameter from the multiplexed signal, and supplying the extracted transmission parameter to the first demodulation unit; and extracting the transmission parameter from the multiplexed signal, and supplying the extracted transmission parameter to the second demodulation unit.

In another aspect of the present disclosure, the first demodulation unit demodulates a multiplexed signal formed by multiplexing data and a transmission parameter that is located in a specific position timewise and includes a parameter necessary for demodulating the data, and the second demodulation unit demodulates the multiplexed signal. Multiplexed signals from the first and second demodulation units are then combined. The transmission parameter is extracted from the multiplexed signal, and the extracted transmission parameter is supplied to the first demodulation unit. The transmission parameter is extracted from the multiplexed signal, and the extracted transmission parameter is supplied to the second demodulation unit.

### EFFECTS OF THE INVENTION

The present technology can realize diversity. More particularly, the present technology can realize diversity in reception of data including transmission parameters in specific positions timewise. Thus, signal quality can be improved.

It should be noted that the advantageous effects described in this specification are merely examples, and the advantageous effects of the present technology are not limited to them and may include some additional effects.

### BRIEF DESCRIPTION OF DRAWINGS

Fig. 1 is a diagram showing an example configuration of a digital signal compliant with the DVB-T2 standards.
Fig. 2 is a block diagram showing an example configuration of a reception device that receives T2 frames.
Fig. 3 is a diagram showing an example operation schedule in the reception device shown in Fig. 2.
Fig. 4 is a block diagram showing an example configuration of a diversity reception device that achieves diversity.
Fig. 5 is a diagram showing an example operation schedule in the reception device shown in Fig. 4.
Fig. 6 is a block diagram showing an example configuration of a first embodiment of a reception device to which the present technology is applied.
Fig. 7 is a diagram showing an example operation schedule in the reception device shown in Fig. 6.
Fig. 8 is a diagram showing another example operation schedule in the reception device shown in Fig. 6.
Fig. 9 is a block diagram showing an example configuration of a reception device that forms the reception device of Fig. 6 by connecting two LSIs.
Fig. 10 is a block diagram showing a reception device in accordance with the invention as defined in the independent claims.
Fig. 11 is a diagram showing an example operation schedule in the reception device shown in Fig. 10.
Fig. 12 is a block diagram showing an example configuration of a reception device that forms the reception device of Fig. 10 by connecting two LSIs.
Fig. 13 is a diagram illustrating an example configuration of a computer.

### MODES FOR CARRYING OUT THE INVENTION

The following is a description of modes for carrying out the present disclosure (hereinafter referred to as the embodiments). It should be noted that explanation will be made in the following order.
0. Outline
1. First Embodiment not forming part of the invention as defined in the independent claims
2. Second Embodiment in accordance with the invention as defined in the independent claims
3. Third Embodiment (Computer)

### <0. Outline>

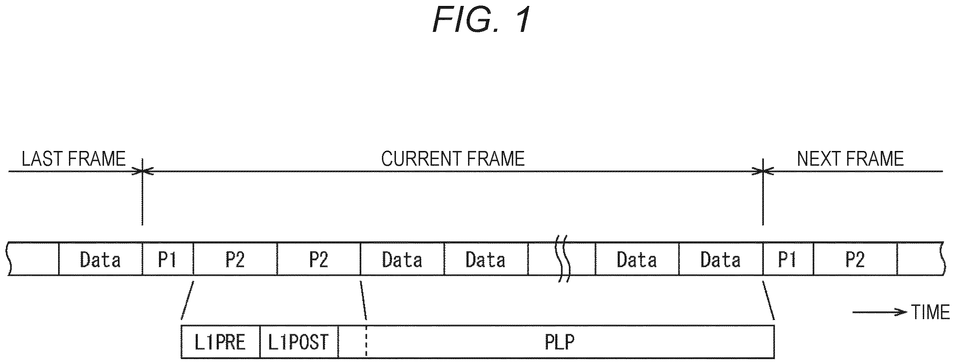

Fig. 1 is a diagram showing an example configuration of a digital signal compliant with the second generation digital terrestrial television broadcasting system (DVB-T2) standards.

As shown in Fig. 1, in a digital signal compliant with the DVB-T2 standards (hereinafter referred to as a DVB-T2 signal), frames called T2 frames are defined, and data is transmitted on a T2 frame basis. A T2 frame includes a P1 symbol, P2 symbols, and data symbols in this order.

A T2 frame includes two kinds of preamble signals called P1 and P2, and the preamble signals contain necessary information as signals for performing processing such as demodulation of orthogonal frequency division multiplexing (OFDM) signals. Hereinafter, the information necessary for performing processing such as demodulation of OFDM signals will be collectively referred to as transmission parameters.

In P1, the information described below is contained as signals. These pieces of information are the information necessary for demodulating P2.

a. Frame identification: T2 frame or future extension frame (FEF)
b. Transmission method: Single Input Single Output (SISO) or Multiple Input Single Output (MISO)
c. FFTSIZE: the number of IFFT points
d. Part of GI length: a total of seven kinds of guard intervals (GIs) are classified into two groups, and this information indicates which one of the groups is being currently sent.

As for P2 symbols, a total of six kinds of FFTSIZE, which are 1K, 2K, 4K, 8K, 16K, and 32K, and a total of seven kinds of GI lengths, which are 1/128, 1/32, 1/16, 19/256, 1/8, 19/128, and 1/4, are defined. The same FFTSIZE and the same GI length as those of symbols (Normal and FCS) excluding P1 and P2 are selected as the FFTSIZE and the GI length of the P2 symbols. GI length information is necessary in demodulating P2, and therefore, there is a need to carry out a GI length estimation process using P2 symbols and data symbols.

In P2, information called L1 (L1PRE/L1POST) is included as signals. L1PRE includes the information that is shown below and is necessary for demodulating L1POST, and the information necessary particularly for demodulating data symbols is included as signals in L1PRE.

e. GI length
f. The interval pattern of known signals called scattered pilots (SPs) in a temporal/frequency direction
g. The number of symbols in one frame (hereinafter referred to as NDSYM)
h. The modulation method for L1POST

It should be noted that L1POST includes the following parameters necessary for processing a PLP (a data stream).
i. The modulation method/code rate for PLP
j. PLP length and PLP position

Further, a PLP is stored in the data symbols, and the PLP is processed so that a TS packet can be extracted. As described above, a DVB-T2 signal is a signal that is formed by multiplexing data and transmission parameters that are arranged in specific positions timewise and include the parameters necessary for demodulating the data. It should be noted that L1 (L1PRE/L1POST) and PLP are LDPC-encoded signals, and therefore, need to be subjected to LDPC decoding in a reception device.

### [Example Configuration of a Reception Device]

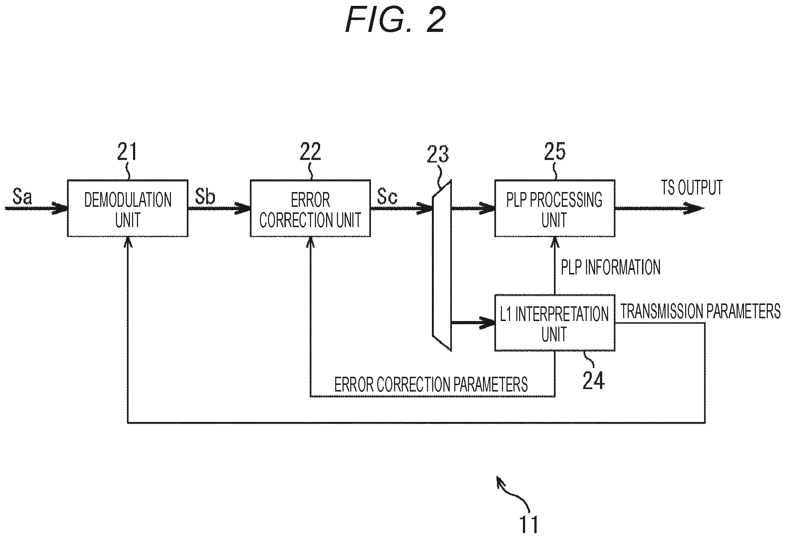

Fig. 2 is a block diagram showing a reception device that receives T2 frames.

In the example shown in Fig. 2, a reception device 11 includes a demodulation unit 21, an error correction unit 22, an output switching unit 23, an L1 interpretation unit 24, and a PLP processing unit 25.

A broadcast wave from a broadcasting station (not shown) is received by the reception device 11, and is supplied as an input signal Sa that is an IF signal or a baseband signal to the demodulation unit 21 by a tuner or the like (not shown). The demodulation unit 21 performs orthogonal demodulation on the input signal Sa, and supplies the resultant baseband OFDM signal as an output signal Sb to the error correction unit 22.

The output signal Sb is a so-called OFDM frequency domain signal already subjected to fast Fourier transform (FFT) arithmetic processing. As described above with reference to Fig. 1, a T2 frame includes a P1 symbol, P2 symbols, and data symbols. Of these symbols, the P1 symbol is removed at the time of outputting from the demodulation unit 21. That is, an OFDM frequency domain signal formed with P2 symbols and data symbols is supplied to the error correction unit 22.

The error correction unit 22 is formed with a so-called LDPC decoder, for example. The error correction unit 22 extracts L1 (L1PRE/L1POST) and the PLP portion from the input Sb formed with P2 symbols and data symbols, and performs LDPC decoding on the LDPC codes of L1 and PLP. The error correction unit 22 then supplies an output signal Sc as the result of the decoding to the output switching unit 23.

The output signal Sc includes the L1 and PLP subjected to error correction. The output switching unit 23 supplies the L1 portion of the output signal Sc to the L1 interpretation unit 24, and the PLP portion to the PLP processing unit 25.

From L1 as the input signal, the L1 interpretation unit 24 interprets the transmission parameters formed with the above mentioned e, f, g, and the like, which are necessary for the processing in the demodulation unit 21, the error correction parameters that indicate the modulation method/code rate or the like and are the information necessary for the error correction unit 22, and the PLP information that indicates the position, the size, and the like of the PLP and is the information necessary for the PLP processing unit 25. The L1 interpretation unit 24 then supplies these pieces of information to the respective blocks.

In accordance with the PLP information supplied from the L1 interpretation unit 24, the PLP processing unit 25 extracts a TS packet from the PLP, and outputs the TS packet to the subsequent stage (not shown).

In the reception device 11 that receives a T2 frame in such a manner, the processing of L1 (L1PRE/L1POST) and PLP characteristically shares the demodulation unit 21 and the error correction unit 22, because of the standardized configuration.

### [Example of an Operation Schedule]

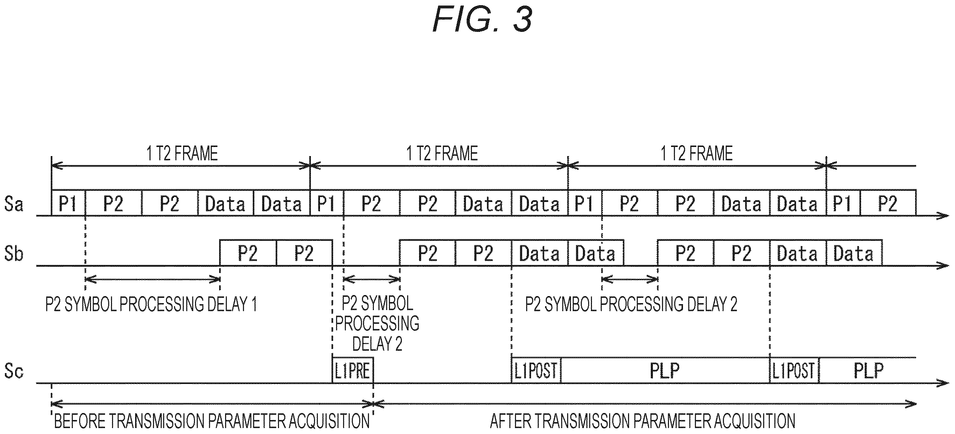

Referring now to Fig. 3, the operation timing in the reception device 11 is described. The example in Fig. 3 shows the operation schedule in the first half before transmission parameters are acquired, and the operation schedule in the second half after the transmission parameters are acquired.

Before the transmission parameters are acquired, the demodulation unit 21 cannot process any data symbol as described above. The demodulation unit 21 detects P1 from the input signal Sa and acquires the P1 signals. The demodulation unit 21 then estimates the GI length from the FFTSIZE and the part of the GI length acquired from the P1 signals.

After the P1 signals and the GI length are acquired, the P2 symbols can be processed. The demodulation unit 21 processes only the P2 symbols, and outputs an output signal Sb formed only with the P2 symbols.

From the output signal Sb, the error correction unit 22 extracts L1PRE in which error correction parameters are uniquely defined. The error correction unit 22 then performs LDPC decoding on the L1PRE, and outputs an output signal Sc formed with the L1PRE. The output switching unit 23 supplies the output signal Sc to the L1 interpretation unit 24.

From the output signal Sc, the L1 interpretation unit 24 interprets the transmission parameters included in the L1PRE, and supplies the transmission parameters to the demodulation unit 21. With this, the demodulation unit 21 can process data symbols in the later frames.

The L1 interpretation unit 24 also interprets the error correction parameters that are included in the L1PRE and are related to L1POST, and supplies the error correction parameters to the error correction unit 22. With this, the error correction unit 22 can process L1POST in the later frames.

After the transmission parameters are acquired, the demodulation unit 21 sequentially processes P2 symbols and data symbols from an input signal Sa, and outputs an output signal Sb formed with the P2 symbols and the data symbols. The delay in the P2 symbol processing in the demodulation unit 21 between an input signal Sa and an output signal Sb before the acquisition of the transmission parameters is longer than the delay in the P2 symbol processing after the acquisition of the transmission parameters, because the delay necessary for processing the above described P1 signals necessary for the processing of P2 and the delay necessary for estimating GI are added to the delay in the P2 symbol processing.

The error correction unit 22 extracts L1POST from the output signal Sb, performs LDPC decoding on the L1POST, and outputs an output signal Sc formed with the L1POST. The output switching unit 23 supplies the output signal Sc to the L1 interpretation unit 24.

From the output signal Sc, the L1 interpretation unit 24 interprets the error correction parameters that are included in the L1POST and are related to PLP, and supplies the error correction parameters to the error correction unit 22. The L1 interpretation unit 24 also interprets the PLP information included in the L1POST, and supplies the PLP information to the PLP processing unit 25. This enables processing of PLP.

The error correction unit 22 extracts PLP from the output signal Sb, performs LDPC decoding on the PLP, and outputs an output signal Sc formed with the PLP. The output switching unit 23 supplies the output signal Sc to the PLP processing unit 25. In accordance with the PLP information supplied from the L1 interpretation unit 24, the PLP processing unit 25 extracts a TS packet from the PLP, and outputs the TS packet to the subsequent stage.

Here, to improve reception performance in mobile environments, diversity techniques involving multiple reception devices have been developed, and today, there is a demand for diversity under the DVB-T2 standards.

### [Example Configuration of a Reception Device]

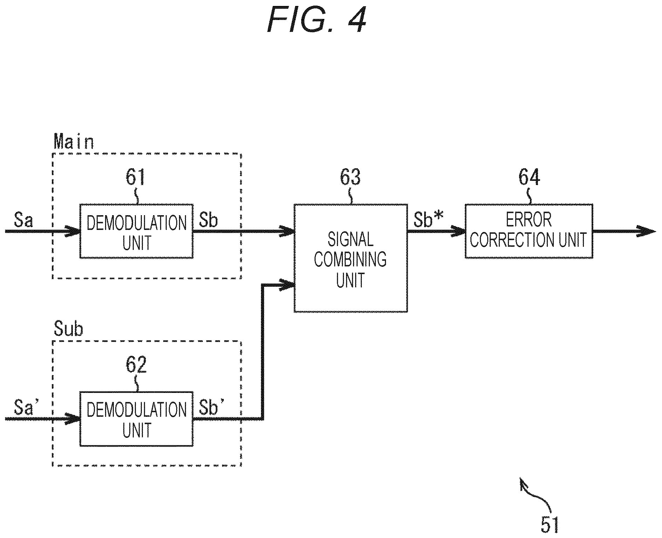

Fig. 4 is a block diagram showing an example configuration of a diversity reception device that achieves diversity.

In the example shown in Fig. 4, a reception device 51 includes a demodulation unit 61 and a demodulation unit 62 that are of two systems and have the same structures. It should be noted that, in the description below, the demodulation unit 61 is of the Main side, and the demodulation unit 62 is of the Sub side. The reception device 51 further includes a signal combining unit 63 that typically performs maximum ratio combining (MRC), and an error correction unit 64.

The signal combining unit 63 combines output signals Sb and Sb' from the respective demodulation units 61 and 62 after weighting the signals in accordance with reception quality (SNR), and outputs a result sb*2 of the combining to the error correction unit 64. The error correction unit 64 decodes the result of the combining supplied from the signal combining unit 63. A diversity reception device normally has such a structure, and, with this structure, is capable of achieving a higher reception quality than in a case where no combining is performed.

However, in a reception device that receives a DVB-T2 signal formed by multiplexing data and transmission parameters that are placed in specific positions timewise and include the parameters necessary for demodulating the data, the timing to output a signal from a demodulation unit varies before and after the acquisition of the transmission parameters, as described above. Therefore, it is difficult to realize diversity only with a mechanism for simply combining outputs of the respective demodulation units.

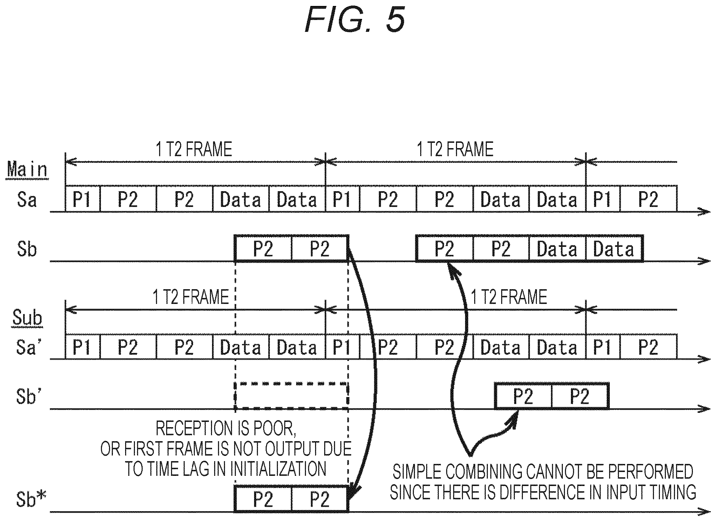

In an example shown in Fig. 5, an output signal Sb formed only with P2 symbols on the Main side is output. Meanwhile, on the Sub side, the processing before the acquisition of the transmission parameters on the Sub side differs from that on the Main side due to a reception condition or the timing of initialization at the start of operation. Therefore, the output signals Sb and Sb' from the respective demodulation units do not match. Because of this, it is difficult for the signal combining unit 63 to combine a signal on the Main side and a signal on the Sub side.

In view of this, according to the present technology, the demodulation units of Main and Sub are notified of transmission parameters supplied from the L1 interpretation unit, and combining is performed on signals obtained before the acquisition of the transmission parameters and signals obtained after the acquisition of the transmission parameters. The following is a detailed description of the present technology.

### <1. First Embodiment not forming part of the invention as defined in the independent claims>

### [Example Configuration of a Reception Device]

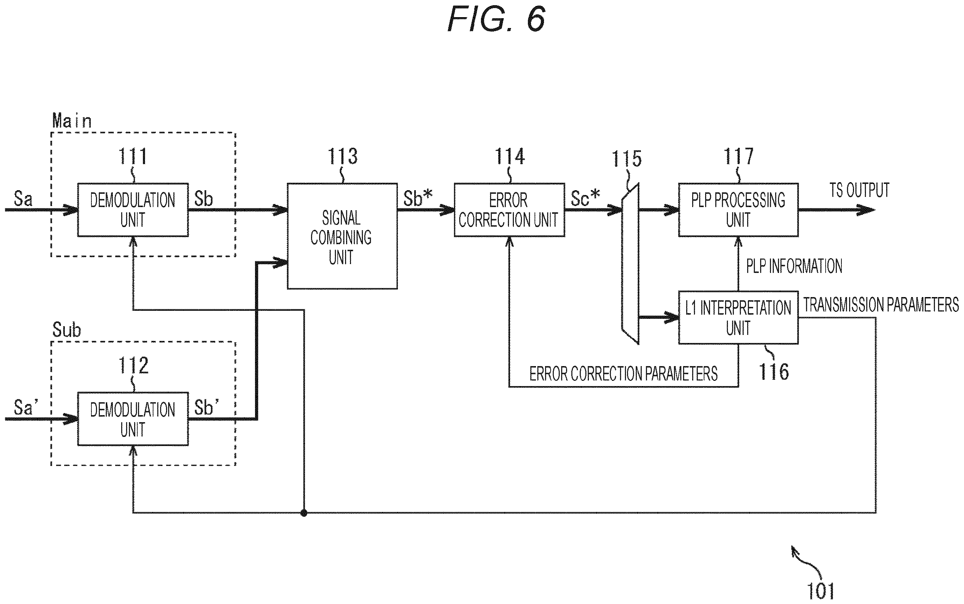

Fig. 6 is a block diagram showing an example configuration of a first embodiment of a reception device to which the present technology is applied.

In the example shown in Fig. 6, a reception device 101 includes a demodulation unit 111 and a demodulation unit 112 that are of two systems and have the same structures, a signal combining unit 113, an error correction unit 114, an output switching unit 115, an L1 interpretation unit 116, and a PLP processing unit 117.

A broadcast wave from a broadcasting station (not shown) is received by the reception device 101, and is supplied as input signals Sa and Sa' that are IF signals or baseband signals to the demodulation units 111 and 112, respectively, by a tuner or the like (not shown). Here, the demodulation unit 111 is the demodulation unit on the Main side, and basically has a configuration similar to that of the demodulation unit 61 shown in Fig. 4. Also, the demodulation unit 112 is the demodulation unit on the Sub side, and basically has a configuration similar to that of the demodulation unit 62 shown in Fig. 4.

That is, the demodulation unit 111 performs orthogonal demodulation on the input signal Sa, and supplies the resultant baseband OFDM signal as an output signal Sb to the signal combining unit 113. The demodulation unit 112 performs orthogonal demodulation on the input signal Sa', and supplies the resultant baseband OFDM signal as an output signal Sb' to the signal combining unit 113.

The signal combining unit 113 has a configuration similar to that of the signal combining unit 63 shown in Fig. 4. The signal combining unit 113 combines the outputs from the respective demodulation units 111 and 112 after weighting the signals in accordance with reception quality (SNR), and outputs a result Sb* of the combining to the error correction unit 114. The error correction unit 114 has a configuration similar to that of the error correction unit 64 shown in Fig. 4. The error correction unit 114 decodes the result of the combining supplied from the signal combining unit 113, and outputs the result to the output switching unit 115.

The output switching unit 115 has a configuration similar to that of the output switching unit 23 shown in Fig. 2. The output switching unit 115 supplies the L1 portion of an output signal Sc* to the L1 interpretation unit 116, and the PLP portion to the PLP processing unit 117.

The L1 interpretation unit 116 has a configuration similar to that of the L1 interpretation unit 24 shown in Fig. 2. From L1 as the input signal, the L1 interpretation unit 116 interprets the transmission parameters formed with the above mentioned e, f, g, and the like, which are necessary for the processing in the demodulation units 111 and 112, the error correction parameters that indicate the modulation method/code rate or the like and are the information necessary for the error correction unit 114, and the PLP information that indicates the position, the size, and the like of the PLP and is the information necessary for the PLP processing unit 117. The L1 interpretation unit 116 then supplies these pieces of information to the respective blocks.

The PLP processing unit 117 has a configuration similar to that of the PLP processing unit 25 shown in Fig. 2. In accordance with the PLP information supplied from the L1 interpretation unit 116, the PLP processing unit 117 extracts a TS packet from the PLP, and outputs the extracted TS packet to the subsequent stage.

### [Example of an Operation Schedule]

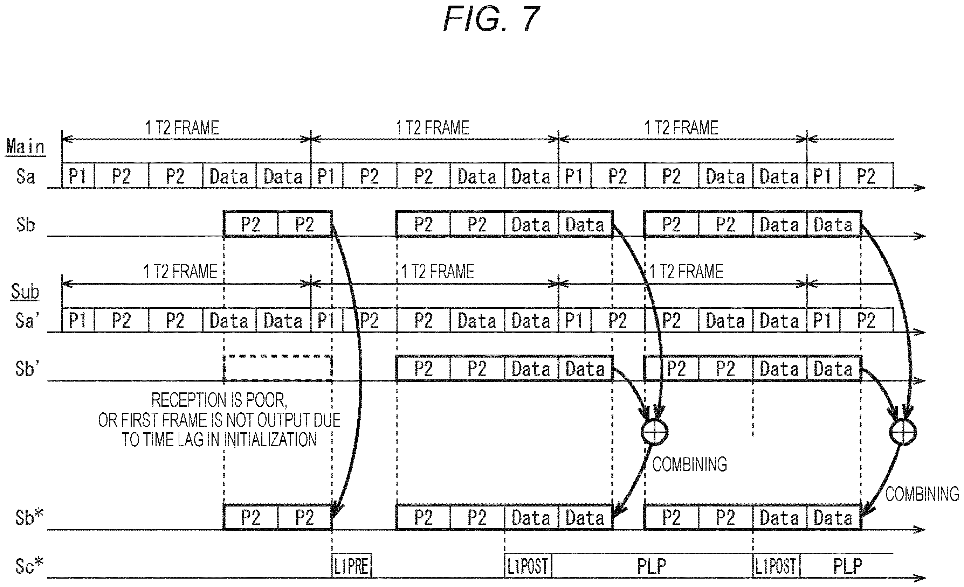

Referring now to Fig. 7, the operation timing in the reception device 101 is described. The example in Fig. 7 shows the operation timing in a situation where the processing before the acquisition of the transmission parameters on the Sub (demodulation unit 112) side differs from that on the Main (demodulation unit 111) side due to a reception condition or the timing of initialization at the start of operation on the Sub side, and therefore, the output signals Sb and Sb' from the respective demodulation units 111 and 112 do not match.

In a first T2 frame, the demodulation unit 111 of Main outputs an output signal Sb formed only with P2 symbols. Meanwhile, the demodulation unit 112 of Sub does not output any output signal Sb', because the reception condition is too poor to acquire P1 signals, for example.

Since any output signal Sb' is not input to the signal combining unit 113, the signal combining unit 113 does not perform combining, and outputs an output signal Sb* = Sb. The signal combining unit 113 combines signals only after the acquisition of transmission parameters. The error correction unit 114 extracts L1PRE from the output signal Sb*, performs LDPC decoding on the L1PRE, and outputs an output signal Sc* formed with the L1PRE. The output switching unit 115 supplies the output signal Sc* to the L1 interpretation unit 116.

From the output signal Sc*, the L1 interpretation unit 116 interprets the transmission parameters included in the L1PRE, and supplies the transmission parameters to the demodulation unit 111 and the demodulation unit 112. The L1 interpretation unit 116 also interprets the error correction parameters that are included in the L1PRE and are related to L1POST, and supplies the error correction parameters to the error correction unit 114.

In a second T2 frame, the demodulation unit 111 of Main sequentially processes P2 symbols and data symbols from an input signal Sa, and outputs an output signal Sb formed with the P2 symbols and the data symbols. Having been supplied with the transmission parameters, the demodulation unit 112 of Sub sequentially processes P2 symbols and data symbols from an input signal Sa' like the demodulation unit 111, and outputs an output signal Sb' formed with the P2 symbols and the data symbols.

The signal combining unit 113 combines the output signals Sb and Sb' obtained after the acquisition of the transmission parameters, and outputs an output signal Sb*. The error correction unit 114 extracts L1POST from the output signal Sb*, performs LDPC decoding on the L1POST, and outputs an output signal Sc* formed with the L1POST. The output switching unit 115 supplies the output signal Sc* to the L1 interpretation unit 116.

From the output signal Sc*, the L1 interpretation unit 116 interprets the error correction parameters that are included in the L1POST and are related to PLP, and supplies the error correction parameters to the error correction unit 114. The L1 interpretation unit 116 also interprets the PLP information included in the L1POST, and supplies the PLP information to the PLP processing unit 117. In accordance with the PLP information supplied from the L1 interpretation unit 116, the PLP processing unit 117 extracts a TS packet from the PLP, and outputs the TS packet to the subsequent stage.

It should be noted that the operation to be performed in each of the third and later T2 frames is similar to that in the second T2 frame, and therefore, explanation thereof is not repeated herein.

As described above, diversity can be realized in the reception device 101 shown in Fig. 6. Thus, improvement of PLP signal quality by virtue of diversity can be expected.

### [Example of an Operation Schedule]

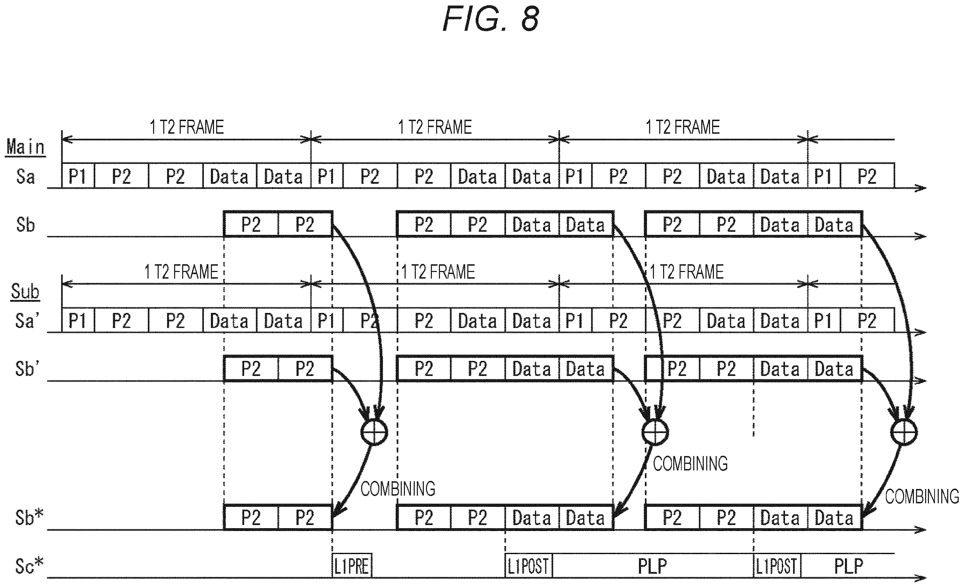

Referring now to Fig. 8, the operation timing in the reception device of Fig. 6 in a different case from that shown in Fig. 7 is described. The example in Fig. 8 shows the operation timing in a situation where the timing of processing before the acquisition of transmission parameters is the same between the Main side and the Sub side.

In a first T2 frame, the demodulation unit 111 of Main outputs an output signal Sb formed only with P2 symbols. Meanwhile, the demodulation unit 112 of Sub also outputs an output signal Sb' formed only with P2 symbols.

The signal combining unit 113 combines the output signals Sb and Sb' formed only with P2 symbols, and outputs an output signal Sb*. The error correction unit 114 extracts L1PRE from the output signal Sb*, performs LDPC decoding on the L1PRE, and outputs an output signal Sc* formed with the L1PRE. The output switching unit 115 supplies the output signal Sc* to the L1 interpretation unit 116.

From the output signal Sc*, the L1 interpretation unit 116 interprets the transmission parameters included in the L1PRE, and supplies the transmission parameters to the demodulation unit 111 and the demodulation unit 112. The L1 interpretation unit 116 also interprets the error correction parameters that are included in the L1PRE and are related to L1POST, and supplies the error correction parameters to the error correction unit 114.

It should be noted that the operation to be performed in each of the second and later T2 frames is similar to that in the first T2 frame described above with reference to Fig. 7, and therefore, explanation thereof is not repeated herein.

In a case where the timing of processing before the acquisition of transmission parameters is the same on both sides as in the case shown in Fig. 8, the reception device 101 shown in Fig. 6 can be expected to improve not only PLP signal quality but also L1PRE signal quality by virtue of diversity.

### [Example Configuration of a Reception Device]

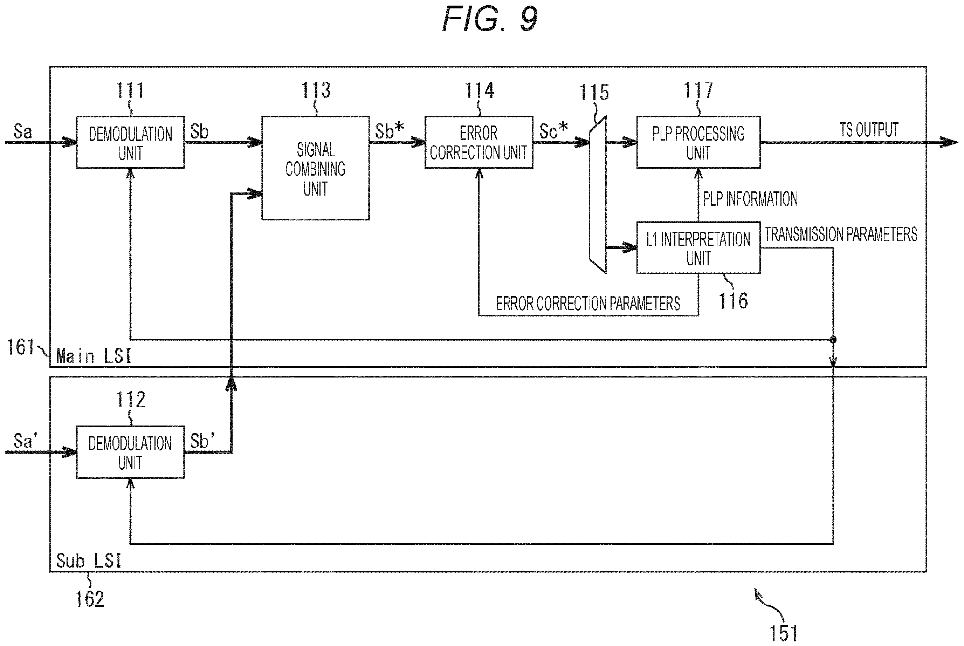

Fig. 9 is a diagram showing an example configuration of a reception device that forms the reception device 101 of Fig. 6 by connecting two LSIs.

In the example shown in Fig. 9, a reception device 151 is formed with a Main LSI 161 and a Sub LSI 162. In the Main LSI 161, the demodulation unit 111, the signal combining unit 113, the error correction unit 114, the output switching unit 115, the L1 interpretation unit 116, and the PLP processing unit 117, which are shown in Fig. 6, are formed. In the Sub LSI 162, the demodulation unit 112 shown in Fig. 6 is formed.

As for communication between the LSIs in the example shown in Fig. 9, an output signal Sb' is input from the demodulation unit 112 in the Sub LSI 162 to the signal combining unit 113 in the Main LSI 161. Also, the demodulation unit 112 in the Sub LSI 162 is notified of (supplied with) transmission parameters from the L1 interpretation unit 116 in the Main LSI 161.

A technique for realizing diversity by connecting LSIs as in the example shown in Fig. 9 is drawing attention, because of its versatility.

In the example case shown in Fig. 9, however, the mechanism for notifying the Sub LSI 162 of transmission parameters from the Main LSI 161 is required, and the amount of communication between the LSIs becomes larger, resulting in problems such as greater power consumption and higher costs.

A second embodiment designed to counter such problems is described below.

### <2. Second Embodiment in accordance with the invention as defined in the independent claims>

### [Configuration of a Reception Device]

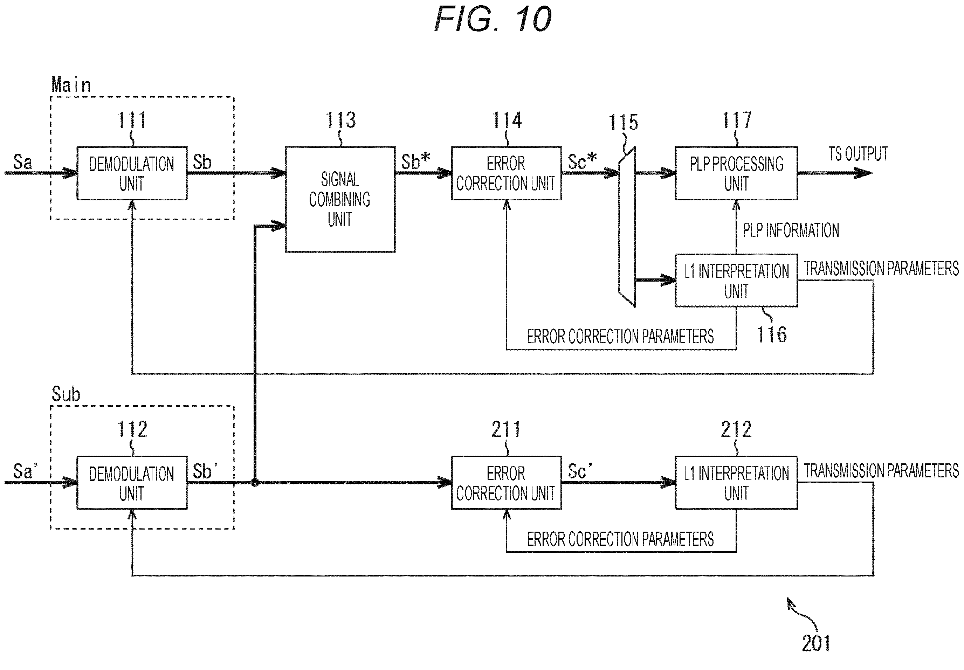

Fig. 10 is a block diagram showing a reception device in accordance with the invention as defined in the independent claims.

In Fig. 10, a reception device 201 includes a demodulation unit 111 and a demodulation unit 112, a signal combining unit 113, an error correction unit 114, an output switching unit 115, an L1 interpretation unit 116, and a PLP processing unit 117, like the reception device 101 shown in Fig. 6.

The reception device 201 differs from the reception device 101 of Fig. 6 in further including an error correction unit 211 and an L1 interpretation unit 212 for the demodulation unit 112 on the Sub side. Further, the L1 interpretation unit 116 differs from the L1 interpretation unit 116 of Fig. 6 in having no need to send transmission parameters to the demodulation unit 112 and in transmitting transmission parameters only to the demodulation unit 111.

Specifically, the demodulation unit 112 on the Sub side performs orthogonal demodulation on an input signal Sa', and supplies the resultant baseband OFDM signal as an output signal Sb' to the error correction unit 211 as well as to the signal combining unit 113.

The error correction unit 211 has a configuration similar to that of the error correction unit 114 shown in Fig. 6. The error correction unit 211 decodes the signal from the demodulation unit 112, and outputs the result to the L1 interpretation unit 212. The L1 interpretation unit 212 has a configuration similar to that of the L1 interpretation unit 116 shown in Fig. 6. From L1 as the input signal, the L1 interpretation unit 212 interprets the transmission parameters formed with the above mentioned e, f, g, and the like, which are necessary for the processing in the demodulation unit 112, the error correction parameters that indicate the modulation method/code rate or the like and are the information necessary for the error correction unit 211, and the PLP information that indicates the position, the size, and the like of PLP, and is the information necessary for the PLP processing unit 117. The L1 interpretation unit 212 then supplies the transmission parameters to the demodulation unit 112, and the error correction parameters to the error correction unit 211.

### [Example of an Operation Schedule]

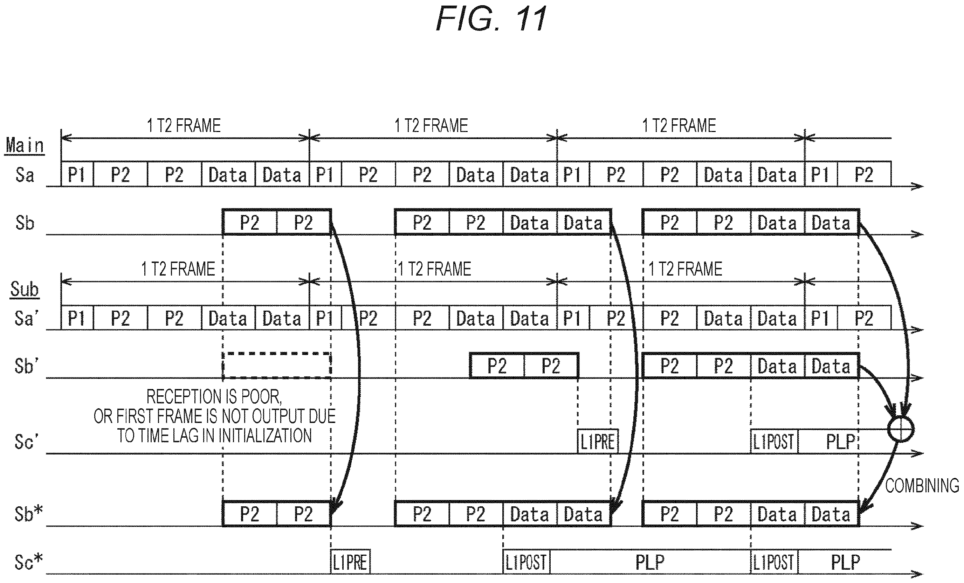

Referring now to Fig. 11, the operation timing in the reception device 201 is described. The example in Fig. 11 shows the operation timing in a situation where the processing before the acquisition of the transmission parameters on the Sub (demodulation unit 112) side differs from that on the Main (demodulation unit 111) side due to a reception condition or the timing of initialization at the start of operation on the Sub side, and therefore, the output signals Sb and Sb' from the respective demodulation units do not match, as in the example shown in Fig. 7.

In a first T2 frame, the demodulation unit 111 of Main outputs an output signal Sb formed only with P2 symbols. Meanwhile, the demodulation unit 112 of Sub does not output any output signal Sb', because the reception condition is too poor to acquire P1 signals, for example.

The signal combining unit 113 does not perform combining, and outputs an output signal Sb* = Sb, as the signal combining unit 113 combines signals only after the acquisition of transmission parameters. The error correction unit 114 extracts L1PRE from the output signal Sb*, performs LDPC decoding on the L1PRE, and outputs an output signal Sc* formed with the L1PRE. The output switching unit 115 supplies the output signal Sc* to the L1 interpretation unit 116.

From the output signal Sc*, the L1 interpretation unit 116 interprets the transmission parameters included in the L1PRE, and supplies the transmission parameters to the demodulation unit 111. The L1 interpretation unit 116 also interprets the error correction parameters that are included in the L1PRE and are related to L1POST, and supplies the error correction parameters to the error correction unit 114.

In a second T2 frame, the demodulation unit 111 of Main sequentially processes P2 symbols and data symbols from an input signal Sa, and outputs an output signal Sb formed with the P2 symbols and the data symbols to the signal combining unit 113. Meanwhile, the demodulation unit 112 of Sub outputs an output signal Sb' formed only with P2 symbols to the signal combining unit 113 and the error correction unit 211.

The signal combining unit 113 does not perform combining, and outputs an output signal Sb* = Sb, as the signal combining unit 113 combines signals only after the acquisition of transmission parameters. The error correction unit 114 extracts L1PRE from the output signal Sb*, performs LDPC decoding on the L1PRE, and outputs an output signal Sc* formed with the L1PRE. The output switching unit 115 supplies the output signal Sc* to the L1 interpretation unit 116.

From the output signal Sc*, the L1 interpretation unit 116 interprets the error correction parameters that are included in the L1POST and are related to PLP, and supplies the error correction parameters to the error correction unit 114. The L1 interpretation unit 116 also interprets the PLP information included in the L1POST, and supplies the PLP information to the PLP processing unit 117.

Meanwhile, the error correction unit 211 extracts L1PRE from the output signal Sb', performs LDPC decoding on the L1PRE, and outputs an output signal Sc' formed with the L1PRE to the L1 interpretation unit 212.

From the output signal Sc', the L1 interpretation unit 212 interprets the transmission parameters included in the L1PRE, and supplies the transmission parameters to the demodulation unit 112. The L1 interpretation unit 212 also interprets the error correction parameters that are included in the L1PRE and are related to L1POST, and supplies the error correction parameters to the error correction unit 211.

In a third T2 frame, the demodulation unit 111 and the demodulation unit 112 sequentially process P2 symbols and data symbols from input signals Sa and Sa', respectively, and output output signals Sb and Sb' formed with the P2 symbols and the data symbols. It should be noted that the demodulation unit 111 outputs the output signal to the signal combining unit 113, and the demodulation unit 112 outputs the output signal to the signal combining unit 113 and the error correction unit 211. The signal combining unit 113 combines the signals Sb and Sb' obtained after the acquisition of the transmission parameters, and outputs an output signal Sb*.

The operation to be performed in each of the T2 frames thereafter is similar to that in the second T2 frame, and therefore, explanation thereof is not repeated herein.

### [Example Configuration of a Reception Device]

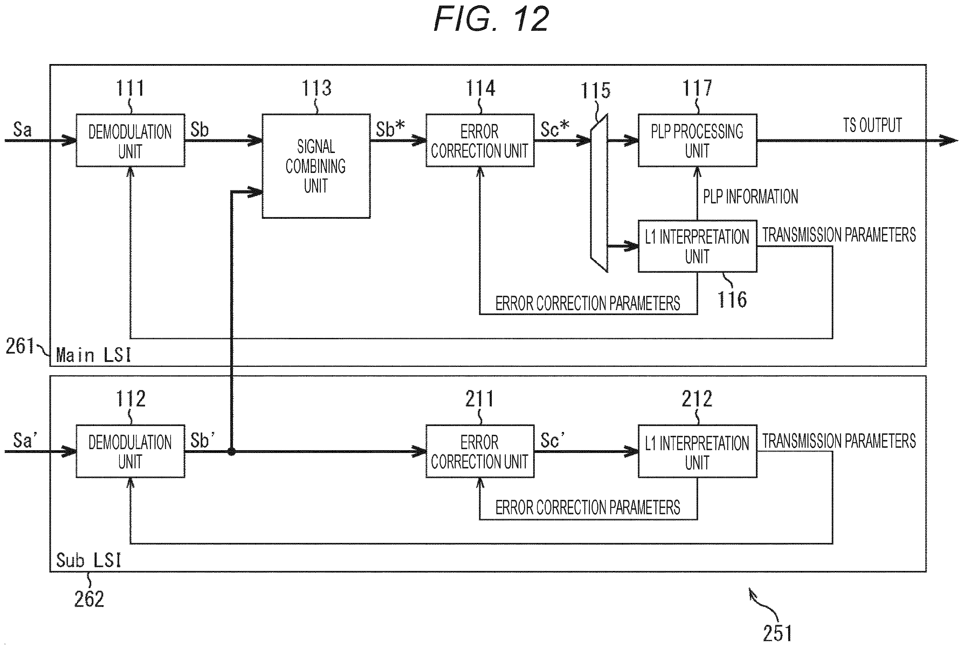

Fig. 12 is a diagram showing an example configuration of a reception device that forms the reception device 201 of Fig. 10 by connecting two LSIs.

In the example shown in Fig. 12, a reception device 251 is formed with a Main LSI 261 and a Sub LSI 262. In the Main LSI 261, the demodulation unit 111, the signal combining unit 113, the error correction unit 114, the output switching unit 115, the L1 interpretation unit 116, and the PLP processing unit 117, which are shown in Fig. 10, are formed. In the Sub LSI 262, the demodulation unit 112, the error correction unit 211, and the L1 interpretation unit 212, which are shown in Fig. 10, are formed.

As for communication between the LSIs in the example shown in Fig. 12, an output signal Sb' is input from the demodulation unit 112 in the Sub LSI 262 to the signal combining unit 113 in the Main LSI 261.

In the example shown in Fig. 12, improvement of PLP signal quality by virtue of diversity can be expected. However, there is the drawback that the signal quality of L1PRE corresponding to the demodulation unit on the Sub side cannot be made higher by diversity than in the reception device 151 shown in Fig. 9. In the case of the reception device 251 in the example shown in Fig. 12, however, the mechanism for notifying the Sub LSI of transmission parameters from the Main LSI is not necessary. Accordingly, power consumption and costs can be advantageously reduced.

As described so far, the present technology can realize diversity under DVB-T2. Thus, improvement of PLP signal quality by virtue of diversity can be expected.

### <3. Third Embodiment>

### [Example of a Computer]

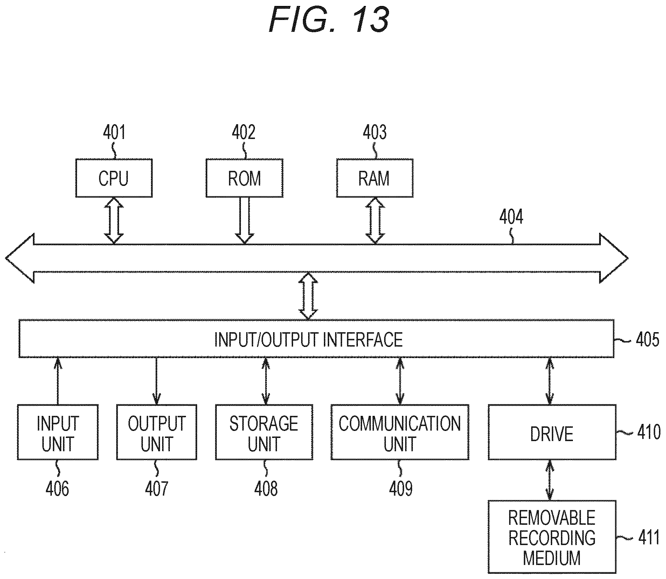

Fig. 13 is a block diagram showing an example configuration of the hardware of a computer that performs the above described series of processes in accordance with a program.

In the computer, a central processing unit (CPU) 401, a read only memory (ROM) 402, and a random access memory (RAM) 403 are connected to one another by a bus 404.

An input/output interface 405 is further connected to the bus 404. An input unit 406, an output unit 407, a storage unit 408, a communication unit 409, and a drive 410 are connected to the input/output interface 405.

The input unit 406 is formed with a keyboard, a mouse, a microphone, and the like. The output unit 407 is formed with a display, a speaker, and the like. The storage unit 408 is formed with a hard disk, a nonvolatile memory, or the like. The communication unit 409 is formed with a network interface or the like. The drive 410 drives a removable recording medium 411 such as a magnetic disc, an optical disc, a magnetooptical disc or a semiconductor memory.

In the computer having the above described configuration, the CPU 401 loads a program stored in the storage unit 408 into the RAM 403 via the input/output interface 405 and the bus 404, for example, and executes the program, so that the above described series of processes are performed.

The program to be executed by the computer (the CPU 401) may be recorded on the removable recording medium 411 as a packaged medium, and be then provided, for example. Alternatively, the program can be provided via a wired or wireless transmission medium, such as a local area network, the Internet, or digital broadcasting.

In the computer, the program can be installed into the storage unit 408 via the input/output interface 405 when the removable recording medium 411 is mounted on the drive 410. The program can also be received by the communication unit 409 via a wired or wireless transmission medium, and be installed into the storage unit 408. Alternatively, the program may be installed beforehand into the ROM 402 or the storage unit 408.

It should be noted that the program to be executed by the computer may be a program for performing processes in chronological order in accordance with the sequence described in this specification, or may be a program for performing processes in parallel or performing a process when necessary, such as when there is a call.

It should be noted that, in this specification, the term "system" means a general apparatus formed with devices, blocks, means, and the like.

It should be noted that embodiments of the present disclosure are not limited to the above described embodiments, and various modifications may be made to them without departing from the scope of the present disclosure.

Furthermore, any configuration described above as one device (or one processing unit) may be divided into two or more devices (or processing units). Conversely, any configuration described above as two or more devices (or processing units) may be combined into one device (or processing unit). Also, it is of course possible to add components other than those described above to the configuration of any of the devices (or processing units). Furthermore, some components of a device (or processing unit) may be incorporated into the configuration of another device (or processing unit) as long as the configuration and the functions of the entire system remain substantially the same. That is, the present technology is not limited to the embodiments described above, but various modifications may be made to them without departing from the scope of the technology.

While preferred embodiments of the present disclosure have been described above with reference to the accompanying drawings, the present disclosure is not limited to those examples. It is apparent that those who have ordinary skills in the art can make various changes or modifications, and it should be understood that those changes or modifications are within the technical scope of the present disclosure.

### REFERENCE SIGNS LIST

- 11: Reception device
- 21: Demodulation unit
- 22: Error correction unit
- 23: Output switching unit
- 24: L1 interpretation unit
- 25: PLP processing unit
- 51: Reception device
- 61: Demodulation unit
- 62: Demodulation unit
- 63: Signal combining unit
- 64: Error correction unit
- 101: Reception device
- 111: Demodulation unit
- 112: Demodulation unit
- 113: Signal combining unit
- 114: Error correction unit
- 115: Output switching unit
- 116: L1 interpretation unit
- 117: PLP processing unit
- 151: Reception device
- 161: Main LSI
- 162: Sub LSI
- 201: Reception device
- 211: Error correction unit
- 212: L1 interpretation unit
- 251: Reception device
- 261: Main LSI
- 262: Sub LSI

## Claims

1. A reception device (201; 251) comprising:
a first demodulation unit (111) configured to demodulate a multiplexed signal (Sa, Sa') formed by multiplexing data and a transmission parameter including a parameter necessary for demodulating the data, the transmission parameter being located in a specific position timewise;
a second demodulation unit (112) configured to demodulate the multiplexed signal (Sa, Sa');
a signal combining unit (113) configured to combine, after acquisition of the transmission parameter, a first demodulated multiplexed signal (Sb) from the first demodulation unit (111) and a second demodulated multiplexed signal (Sb') from the second demodulation unit (112), thereby obtaining a combined signal (Sb*);
a first error correction unit (114) configured to perform error correction on the combined signal (Sb*) thereby obtaining a first output signal (Sc*), and supply the first output signal (Sc*) to a first transmission parameter processing unit (116); and
a second error correction unit (211) configured to perform error correction on the second demodulated multiplexed signal (Sb') thereby obtaining a second output signal (Sc'), and supply the second output signal (Sc') to a second transmission parameter processing unit (212);
the first transmission parameter processing unit (116) being configured to extract the transmission parameter from the first output signal (Sc*), and supply the extracted transmission parameter to the first demodulation unit (111); and
the second transmission parameter processing unit (212) being configured to extract the transmission parameter from the second output signal (Sc'), and supply the extracted transmission parameter to the second demodulation unit (112).

2. The reception device (201; 251) according to claim 1, wherein, when any demodulated multiplexed signal is not input from one of the first (111) and second (112) demodulation units, the signal combining unit (113) is configured to output a demodulated multiplexed signal from the other one of the first (111) and second (112) demodulation units to a subsequent stage as the combined signal.

3. The reception device (201; 251) according to claim 1 or 2, wherein:
the transmission parameter includes an error correction parameter for performing the error correction;
the first transmission parameter processing unit (116) is configured to supply the error correction parameter of the transmission parameter to the first error correction unit (114); and
the second transmission parameter processing unit (212) is configured to supply the error correction parameter of the transmission parameter to the second error correction unit (211).

4. The reception device (201; 251) according to any one of claims 1 to 3, wherein the first demodulation unit (111), the signal combining unit (113), and the first transmission parameter processing unit (116) are disposed in a first large-scale integrated circuit (LSI, 261), and the second demodulation unit (112) and the second transmission parameter processing unit (212) are disposed in a second large-scale integrated circuit (LSI, 262), the second large-scale integrated circuit (LSI, 262) being different from the first large-scale integrated circuit (LSI, 261).

5. A reception method comprising:
demodulating a multiplexed signal (Sa, Sa') formed by multiplexing data and a transmission parameter including a parameter necessary for demodulating the data, the transmission parameter being located in a specific position timewise, the demodulating being performed by a first demodulation unit (111) of a reception device (201; 251);
demodulating the multiplexed signal (Sa, Sa'), the demodulating being performed by a second demodulation unit (112) of the reception device (201; 251);
combining, after acquisition of the transmission parameter, a first demodulated multiplexed signal (Sb) from the first demodulation unit (111) and a second demodulated multiplexed signal (Sb') from the second demodulation unit (112), thereby obtaining a combined signal (Sb*);
performing error correction , by a first error correction unit (114), on the combined signal (Sb*) thereby obtaining a first output signal (Sc*), and supplying the first output signal (Sc*) to a first transmission parameter processing unit (116);
performing error correction, by a second error correction unit (211), on the second demodulated multiplexed signal (Sb') thereby obtaining a second output signal (Sc'), and supplying the second output signal (Sc') to a second transmission parameter processing unit (212);
extracting the transmission parameter from the first output signal (Sc*), the extracting being performed by the first transmission parameter processing unit (116), and supplying the extracted transmission parameter to the first demodulation unit (111); and
extracting the transmission parameter from the second output signal (Sc'), the extracting being performed by the second transmission parameter processing unit (212), and supplying the extracted transmission parameter to the second demodulation unit (112).

## Patentansprüche

1. Empfangsvorrichtung (201; 251) umfassend:
eine erste Demodulationseinheit (111), die konfiguriert ist, um ein Multiplexsignal (Sa, Sa') zu demodulieren, das durch Multiplexen von Daten und einem Übertragungsparameter ausgebildet wird, einschließlich eines für die Demodulation der Daten erforderlichen Parameters, wobei sich der Übertragungsparameter zeitlich an einer bestimmten Position befindet;
eine zweite Demodulationseinheit (112), die konfiguriert ist, um das Multiplexsignal (Sa, Sa') zu demodulieren;
eine Signalkombinationseinheit (113), die konfiguriert ist, um nach der Erfassung des Übertragungsparameters ein erstes demoduliertes Multiplexsignal (Sb) von der ersten Demodulationseinheit (111) und ein zweites demoduliertes Multiplexsignal (Sb') von der zweiten Demodulationseinheit (112) zu kombinieren, wodurch ein kombiniertes Signal (Sb*) erhalten wird;
eine erste Fehlerkorrektureinheit (114), die konfiguriert ist, um eine Fehlerkorrektur an dem kombinierten Signal (Sb*) durchzuführen, wodurch ein erstes Ausgangssignal (Sc*) erhalten wird, und das erste Ausgangssignal (Sc*) an eine erste Übertragungsparameter-Verarbeitungseinheit (116) zu liefern; und
eine zweite Fehlerkorrektureinheit (211), die konfiguriert ist, um eine Fehlerkorrektur an dem zweiten demodulierten Multiplexsignal (Sb') durchzuführen, wodurch ein zweites Ausgangssignal (Sc') erhalten wird, und das zweite Ausgangssignal (Sc') an eine zweite Übertragungsparameter-Verarbeitungseinheit (212) zu liefern;
die erste Übertragungsparameter-Verarbeitungseinheit (116) konfiguriert ist, um den Übertragungsparameter aus dem ersten Ausgangssignal (Sc*) zu extrahieren und den extrahierten Übertragungsparameter an die erste Demodulationseinheit (111) zu liefern; und
die zweite Übertragungsparameter-Verarbeitungseinheit (212) konfiguriert ist, um den Übertragungsparameter aus dem zweiten Ausgangssignal (Sc') zu extrahieren und den extrahierten Übertragungsparameter an die zweite Demodulationseinheit (112) zu liefern.

2. Empfangsvorrichtung (201; 251) nach Anspruch 1, wobei, wenn kein beliebiges demoduliertes Multiplexsignal von einer der ersten (111) und der zweiten (112) Demodulationseinheit eingegeben wird, die Signalkombinationseinheit (113) konfiguriert ist, um ein demoduliertes Multiplexsignal von der anderen der ersten (111) und der zweiten (112) Demodulationseinheit an eine nachfolgende Stufe als das kombinierte Signal auszugeben.

3. Empfangsvorrichtung (201; 251) nach Anspruch 1 oder 2, wobei:
der Übertragungsparameter einen Fehlerkorrekturparameter zum Durchführen der Fehlerkorrektur einschließt;
die erste Übertragungsparameter-Verarbeitungseinheit (116) konfiguriert ist, um den Fehlerkorrekturparameter des Übertragungsparameters an die erste Fehlerkorrektureinheit (114) zu liefern; und
die zweite Übertragungsparameter-Verarbeitungseinheit (212) konfiguriert ist, um den Fehlerkorrekturparameter des Übertragungsparameters an die zweite Fehlerkorrektureinheit (211) zu liefern.

4. Die Empfangsvorrichtung (201; 251) nach einem der Ansprüche 1 bis 3, wobei die erste Demodulationseinheit (111), die Signalkombinationseinheit (113) und die erste Übertragungsparameter-Verarbeitungseinheit (116) in einer ersten Großintegrationsschaltung (LSI, 261) angeordnet sind, und die zweite Demodulationseinheit (112) und die zweite Übertragungsparameter-Verarbeitungseinheit (212) in einer zweiten Großintegrationsschaltung (LSI, 262) angeordnet sind, wobei sich die zweite Großintegrationsschaltung (LSI, 262) von der ersten Großintegrationsschaltung (LSI, 261) unterscheidet.

5. Empfangsverfahren, umfassend:
Demodulieren eines Multiplexsignals (Sa, Sa'), das durch Multiplexen von Daten und eines Übertragungsparameters ausgebildet wird, einschließlich eines für das Demodulieren der Daten erforderlichen Parameters, wobei sich der Übertragungsparameter zeitlich an einer bestimmten Position befindet, wobei die Demodulation durch eine erste Demodulationseinheit (111) einer Empfangsvorrichtung (201; 251) durchgeführt wird;
Demodulieren des Multiplexsignals (Sa, Sa'), wobei das Demodulieren durch eine zweite Demodulationseinheit (112) der Empfangsvorrichtung (201; 251) durchgeführt wird;
Kombinieren, nach der Erfassung des Übertragungsparameters, eines ersten demodulierten Multiplexsignals (Sb) aus der ersten Demodulationseinheit (111) und eines zweiten demodulierten Multiplexsignals (Sb') aus der zweiten Demodulationseinheit (112), wodurch ein kombiniertes Signal (Sb*) erhalten wird;
Durchführen einer Fehlerkorrektur, durch eine erste Fehlerkorrektureinheit (114), an dem kombinierten Signal (Sb*), wodurch ein erstes Ausgangssignal (Sc*) erhalten wird, und Liefern des ersten Ausgangssignals (Sc*) an eine erste Übertragungsparameter-Verarbeitungseinheit (116);
Durchführen einer Fehlerkorrektur, durch eine zweite Fehlerkorrektureinheit (211), an dem zweiten demodulierten Multiplexsignal (Sb'), wodurch ein zweites Ausgangssignal (Sc') erhalten wird, und Liefern des zweiten Ausgangssignals (Sc') an eine zweite Übertragungsparameter-Verarbeitungseinheit (212);
Extrahieren des Übertragungsparameters aus dem ersten Ausgangssignal (Sc*), wobei das Extrahieren durch die erste Übertragungsparameter-Verarbeitungseinheit (116) durchgeführt wird, und Liefern des extrahierten Übertragungsparameters an die erste Demodulationseinheit (111); und
Extrahieren des Übertragungsparameters aus dem zweiten Ausgangssignal (Sc'), wobei das Extrahieren durch die zweite Übertragungsparameter-Verarbeitungseinheit (212) durchgeführt wird, und Liefern des extrahierten Übertragungsparameters an die zweite Demodulationseinheit (112).

## Revendications

1. Dispositif de réception (201 ; 251) comprenant :
une première unité de démodulation (111) configurée pour démoduler un signal multiplexé (Sa, Sa') formé par le multiplexage de données et d'un paramètre de transmission comportant un paramètre nécessaire pour la démodulation des données, le paramètre de transmission étant localisé dans une position temporelle spécifique ;
une seconde unité de démodulation (112) configurée pour démoduler le signal multiplexé (Sa, Sa') ;
une unité de combinaison de signaux (113) configurée pour combiner, après acquisition du paramètre de transmission, un premier signal multiplexé démodulé (Sb) provenant de la première unité de démodulation (111) et un second signal multiplexé démodulé (Sb') provenant de la seconde unité de démodulation (112), ce qui permet d'obtenir un signal combiné (Sb*) ;
une première unité de correction d'erreurs (114) configurée pour mettre en oeuvre une correction d'erreurs sur le signal combiné (Sb*) ce qui permet d'obtenir un premier signal de sortie (Sc*), et approvisionner le premier signal de sortie (Sc*) à une première unité de traitement de paramètre de transmission (116) ; et
une seconde unité de correction d'erreurs (211) configurée pour mettre en oeuvre une correction d'erreurs sur le second signal multiplexé démodulé (Sb') ce qui permet d'obtenir un second signal de sortie (Sc'), et approvisionner le second signal de sortie (Sc') à une seconde unité de traitement de paramètre de transmission (212) ;
la première unité de traitement de paramètre de transmission (116) étant configurée pour extraire le paramètre de transmission du premier signal de sortie (Sc*), et approvisionner le paramètre de transmission extrait à la première unité de démodulation (111) ; et
la seconde unité de traitement de paramètre de transmission (212) étant configurée pour extraire le paramètre de transmission du second signal de sortie (Sc'), et approvisionner le paramètre de transmission extrait à la seconde unité de démodulation (112).

2. Dispositif de réception (201 ; 251) selon la revendication 1, dans lequel, lorsque l'un quelconque signal multiplexé démodulé n'est pas entré à partir de l'une des première (111) et seconde (112) unités de démodulation, l'unité de combinaison de signaux (113) est configurée pour délivrer en sortie un signal multiplexé démodulé à partir de l'autre parmi les première (111) et seconde (112) unités de démodulation à un étage ultérieur en tant que signal combiné.

3. Dispositif de réception (201 ; 251) selon la revendication 1 ou 2, dans lequel :
le paramètre de transmission comporte un paramètre de correction d'erreurs destiné à mettre en oeuvre la correction d'erreurs ;
la première unité de traitement de paramètre de transmission (116) est configurée pour approvisionner le paramètre de correction d'erreurs du paramètre de transmission à la première unité de correction d'erreurs (114) ; et
la seconde unité de traitement de paramètre de transmission (212) est configurée pour approvisionner le paramètre de correction d'erreurs du paramètre de transmission à la seconde unité de correction d'erreurs (211).

4. Dispositif de réception (201 ; 251) selon l'une quelconque des revendications 1 à 3, dans lequel la première unité de démodulation (111), l'unité de combinaison de signaux (113) et la première unité de traitement de paramètre de transmission (116) sont disposées dans un premier circuit intégré à grande échelle (LSI, 261), et la seconde unité de démodulation (112) et la seconde unité de traitement de paramètre de transmission (212) sont disposées dans un second circuit intégré à grande échelle (LSI, 262), le second circuit intégré à grande échelle (LSI, 262) étant différent du premier circuit intégré à grande échelle (LSI, 261).

5. Procédé de réception comprenant :
la démodulation d'un signal multiplexé (Sa, Sa') formé par le multiplexage de données et d'un paramètre de transmission comportant un paramètre nécessaire pour la démodulation des données, le paramètre de transmission étant localisé dans une position temporelle spécifique, la démodulation étant mise en oeuvre par une première unité de démodulation (111) d'un dispositif de réception (201 ; 251) ;
la démodulation du signal multiplexé (Sa, Sa'), la démodulation étant mise en oeuvre par une seconde unité de démodulation (112) du dispositif de réception (201 ; 251) ;
la combinaison, après acquisition du paramètre de transmission, d'un premier signal multiplexé démodulé (Sb) provenant de la première unité de démodulation (111) et d'un second signal multiplexé démodulé (Sb') provenant de la seconde unité de démodulation (112), ce qui permet d'obtenir un signal combiné (Sb*) ;
la mise en oeuvre d'une correction d'erreurs, par une première unité de correction d'erreurs (114), sur le signal combiné (Sb*) ce qui permet d'obtenir un premier signal de sortie (Sc*), et l'approvisionnement du premier signal de sortie (Sc*) à une première unité de traitement de paramètre de transmission (116) ;
la mise en oeuvre d'une correction d'erreurs, par une seconde unité de correction d'erreurs (211), sur le second signal multiplexé démodulé (Sb') ce qui permet d'obtenir un second signal de sortie (Sc'), et l'approvisionnement du second signal de sortie (Sc') à une seconde unité de traitement de paramètre de transmission (212) ;
l'extraction du paramètre de transmission du premier signal de sortie (Sc*), l'extraction étant mise en oeuvre par la première unité de traitement de paramètre de transmission (116), et l'approvisionnement du paramètre de transmission extrait à la première unité de démodulation (111) ; et
l'extraction du paramètre de transmission du second signal de sortie (Sc'), l'extraction étant mise en oeuvre par la seconde unité de traitement de paramètre de transmission (212), et l'approvisionnement du paramètre de transmission extrait à la seconde unité de démodulation (112).
